# EUROPÄISCHE PATENTSCHRIFT

(11) **EP 1 692 718 B1**
(45) Veröffentlichungstag und Bekanntmachung des Hinweises auf die Patenterteilung: **02.05.2007**
(21) Anmeldenummer: 04820417.6
(22) Anmeldetag: 06.12.2004
(51) Int. Cl.: H01L 21/68

(54) **TRÄGER ZUR AUFNAHME EINES GEGENSTANDES SOWIE VERFAHREN ZUR HERSTELLUNG EINES TRÄGERS**
CARRIER FOR RECEIVING AN OBJECT AND METHOD FOR THE PRODUCTION OF A CARRIER
SUPPORT DESTINE A RECEVOIR UN OBJET ET PROCEDE DE FABRICATION DUDIT SUPPORT

(30) Priorität: 09.12.2003 DE 10357698
(43) Veröffentlichungstag der Anmeldung: 23.08.2006
(73) Patentinhaber: Schunk Kohlenstofftechnik GmbH, D-35452 Heuchelheim (DE)
(72) Erfinder: SCHNEWEIS, Stefan, 61279 Grävenwiesbach (DE)
(74) Vertreter: Stoffregen, Hans-Herbert
(86) Internationale Anmeldenummer: PCT/EP2004/013838
(87) Internationale Veröffentlichungsnummer: WO 2005/059992

(56) Entgegenhaltungen:
- US-B1- 6 444 027
- PATENT ABSTRACTS OF JAPAN Bd. 016, Nr. 038 (E-1161), 30. Januar 1992 (1992-01-30) & JP 03 246931 A (TOSHIBA CERAMICS CO LTD), 5. November 1991 (1991-11-05) in der Anmeldung erwähnt
- PATENT ABSTRACTS OF JAPAN Bd. 1997, Nr. 12, 25. Dezember 1997 (1997-12-25) & JP 09 209152 A (TOSHIBA CORP), 12. August 1997 (1997-08-12) in der Anmeldung erwähnt

## Beschreibung

Die Erfindung bezieht sich auf einen Träger zur Aufnahme eines zu behandelnden Gegenstandes, wie Substrat eines Halbleiterbauelementes, wobei der Träger Kohlenstoff enthält und den Träger durchsetzende Gasaustritts- oder Durchtrittsöffnungen aufweist. Ferner nimmt die Erfindung Bezug auf ein Verfahren zur Herstellung eines Trägers zur Aufnahme eines zu behandelnden Gegenstandes, vorzugsweise eines Substrats eines Halbleiterbauelementes wie Wafer, wobei als Material für den Träger Kohlenstoff verwendet wird und in dem Träger diesen durchsetzende Gasaustritts- oder Durchtrittsöffnungen ausgebildet werden.

Ein Gasaustrittsöffnungen aufweisender Träger aus hochreinem Graphit ist der US-B-6,444,027 zu entnehmen. Die Gasaustrittsöffnungen werden durch Bohren des Trägers ausgebildet und weisen Durchmesser zwischen 0,1 und 3 mm auf. Der Graphitträger selbst ist mit einer SiC-Schicht oder transparenten Kohlenstoffschicht abgedeckt.

In dem Dokument selbst wird als Stand der Technik ein aus hochreinem Graphit bestehender Suszeptor abgehandelt, der vollständig mit einer SiC-Schicht abgedeckt ist, um zu verhindern, dass Verunreinigungen aus dem Suszeptor in die Umgebung austreten können.

Um in einer Prozesskammer auch die Rückseite eines flachen Gegenstandes zu reinigen, ist nach der US-A-5,960,555 ein Suszeptor vorgesehen, der Öffnungen aufweist, über die Reinigungsgas auf die Rückseite strömt.

Ein Suszeptor für eine CVD-Anordnung weist nach der JP-A-10223545 Bohrlöcher auf, über die auf der Rückseite eines von der Vorderseite her zu dotierenden Gegenstandes austretende Dotieratome weggeführt werden.

Die GB-A-2 172 822 bezieht sich auf eine aus Fasern bestehende poröse Haltevorrichtung, durch die zum Fixieren eines Werkstücks Luft gesaugt wird.

Um Gegenstände berührungslos zu fördern, wird nach der DE-A-101 45 686 eine Kreisplattenanordnung vorgeschlagen, die Durchgangsbohrungen aufweist, um durch diese Druckgas hindurchzuführen. Alternativ können offenporige Materialien zum Einsatz gelangen. Als Material kommt jegliches Material wie beispielsweise Glas in Frage.

Der WO-A-03/049157 ist eine Transportvorrichtung für Wafer zu entnehmen. Die Vorrichtung besteht aus kohlefaserverstärktem Material, das oberflächenseitig ein elektrisch leitendes Polymer aufweist, um Aufladungen zu vermeiden.

Ein Suszeptor nach der JP-A-11035391 besteht aus einem geschlossenen Körper aus Kohlenstoffmaterial. Ein entsprechender Suszeptor ist auch der US-A-2003/0160044 zu entnehmen, der aus Kohlenstoff besteht und eine geschlossene Oberfläche aufweist.

Ein Suszeptor geringer Masse aus glasartigem Kohlenstoff mit SiC-Beschichtung ist aus der JP-A-08181150 bekannt. Durch die Siliciumkarbidbeschichtung wird der Suszeptor gasundurchlässig.

Nach der JP-A-03246931 wird zur gleichmäßigen Wärmeverteilung ein aus Kohlenstoffmaterial und Kohlenstofffasern bestehender Suszeptor vorgeschlagen, der aus zwei zueinander beabstandeten Platten besteht. In den zwischen den Platten gebildeten Hohlraum führen Bohrungen. Um zu verhindern, dass aus dem Basismaterial Verunreinigungen austreten, wird die Oberfläche mit einem SiC-Film verschlossen.

Zur Behandlung eines Substrats wird dieses nach der JP-A-09209152 auf einem Ring gelagert, der aus einem kunststofffaserverstärkten Material besteht, der außenseitig eine SiC-Schicht aufweist.

Ein Suszeptor aus porösem Kohlenstoff ist aus der JP-A-60254610 bekannt.

Eine Saugvorrichtung nach der JP-A-2000031098 sieht einen aus synthetischem Harz, Kohlenstoff und Ebonit bestehenden Körper mit vertikal verlaufenden Poren vor, um einen auf dem Träger vorhandenen Gegenstand durch Unterdruck zu fixieren.

Der vorliegenden Erfindung liegt.die Aufgabe zu Grunde, einen Träger der eingangs genannten Art sowie ein Verfahren zum Herstellen eines solchen so weiterzubilden, dass über in dem Träger vorhandene Gasaustritt- oder Durchtrittsöffnungen wohl dosiert und fein verteilt ein gewünschtes Gas austreten kann. Gleichzeitig soll die Möglichkeit geschaffen werden, das Gas im gewünschten Umfang definiert zu erwärmen. Ferner soll eine hohe Stabilität gegeben sein. Die Möglichkeit, Träger gewünschter Dimensionierung auf einfache Weise herzustellen, soll gleichfalls erfüllt werden.

Zur Lösung der Aufgabe sieht die Erfindung im Wesentlichen vor, dass der Träger porös ist, dass die Porosität die Gasaustritts- oder Durchtrittsöffnungen bildet, dass der Träger aus einem Gerüst oder einem Abschnitt eines Gerüsts aus C-Fasern und/oder SiC-Fasern besteht, dass die Fasern in einer Matrix aus Kohlenstoff und/oder SiC eingebettet sind und dass Porosität p des Trägers 5 % ≤ p ≤ 95 % und Dichte ρ des Trägers 0,1 g/cm³ ≤ ρ ≤ 3,0 g/cm³ beträgt.

Die Stabilisierung bzw. Versteifung der Fasern erfolgt durch chemische Gasphaseninfiltration (CVI) und/oder Imprägnierung mit flüssigen Substanzen. Hierdurch werden auf den Fasern Kohlenstoff- und/oder Siliziumkarbid-Schichten abgeschieden bzw. solche aus den Fasern ausgebildet. Die Fasern können mit einer Folge aus einer oder mehreren Kohlenstoff- bzw. Siliziumkarbidschichten ummantelt sein, wobei auch ein gradiertes System in Frage kommt, das von Kohlenstoff in Siliziumkarbid übergeht. Gradiert bedeutet dabei, dass vorzugsweise ein stetiger oder nahezu stetiger Übergang erfolgt.

Bei dem Kohlenstoff handelt es sich insbesondere um Pyrokohlenstoff.

Unabhängig hiervon sollte die äußerste Schicht eine insbesondere durch chemische Gasphasenabscheidung erzeugte SiC-Schicht sein, um eine hinreichende chemische Beständigkeit zu erzielen. Gleichzeitig ist auf Grund der diffusionssperrenden Wirkung von Siliziumkarbid sichergestellt, dass nicht oder nur im geringen Umfang eine Kontamination des Trägers durch Verunreinigungen des Basiswerkstoffes erfolgt.

Die Dichte des Trägers ist zwischen 0,1g/cm³ und 3,0 g/cm³ eingestellt, wobei mit steigender Dichte Festigkeit und Wärmeleitfähigkeit des Trägers zunehmen, wohingegen die Gasdurchlässigkeit abnimmt.

Abweichend vom vorbekannten Stand der Technik wird als Träger - auch Suszeptor genannt - ein aus Kohlenstoff- und/oder Siliziumkarbidfasern bestehendes Gerüst benutzt, das durch Ausbilden bzw. Auftragen von Kohlenstoff- bzw. Siliziumkarbidschichten stabilisiert wird. Durch den Umfang der Beschichtung kann die Porosität des Gerüstes eingestellt werden.

Unabhängig hiervon sind durch die Faserstruktur des Gerüstes statistisch verteilte bzw. zufällig angeordnete isotrop verteilte Porenkanäle vorhanden, die von dem mit dem zu behandelnden bzw. zu reinigenden Gegenstand zu beaufschlagenden Gas durchströmt werden. Durch das Durchströmen entsprechender willkürlich verlaufender Porenkanäle erhöht sich die Verweildauer des Gases im Inneren des Trägers, wodurch eine sehr gleichmäßige Erwärmung des Gases gegeben ist. Auf Grund der Vielzahl der Porenkanäle ist des Weiteren ein Gasstrom mit sehr hoher Homogenität erreichbar.

Ein Verfahren zur Herstellung eines Trägers der eingangs genannten Art zeichnet sich durch die Verfahrensschritte aus:
- Herstellen eines Gerüstes aus C- und/oder SiC-Fasern und
- Stabilisieren des Gerüstes mit zumindest einer eine Matrix bildenden Pyrokohlenstoff- und/oder Siliziumcarbidschicht derart, dass das stabilisierte Gerüst eine die Gasaustritts- oder Durchtrittsöffnung bildende Porosität aufweist,
wobei so stabilisiertes Gerüst oder ein Abschnitt des Gerüsts als der Träger verwendet wird.

Dabei kann als Gerüst ein Filz, ein Vlies und Gewebelagen verwendet werden, die aus Kohlenstoff bestehen oder enthalten bzw. in Kohlenstoff umgesetzt werden. Dies kann z. B. durch Verkokung erfolgen. Sodann wird das Gerüst durch Gasphaseninfiltration (CVI) und/oder Flüssigkeitsimprägnierung stabilisiert. Dabei können die Fasern des Gerüstes derart behandelt werden, dass eine Umhüllung aus reinem Kohlenstoff oder reinem Siliziumkarbid entsteht. Auch besteht die Möglichkeit, auf den Fasern eine Folge von Schichten aus einer oder mehreren Kohlenstoffschichten und/oder einer oder mehreren Siliziumkarbidschichten aufzubringen. Auch eine Gradierung von Kohlenstoff in Siliziumkarbid ist möglich.

Unabhängig hiervon sollte als äußere Schicht der Fasern eine Siliziumkarbidschicht ausgebildet werden, um eine hohe chemische Beständigkeit zu erzielen.

Durch Zusammensetzung des Gerüsts und/oder Dauer der Behandlung zum Stabilisieren der Fasern und Ausbilden der Schichten können Dichte, Wärmeleitfähigkeit und/oder Porosität des beschichteten Gerüsts eingestellt werden.

Insbesondere zeichnet sich die Erfindung dadurch aus, dass auf das aus C- und/oder SiC-Fasern bestehende Gerüst eine oder mehrere aus Pyrokohlenstoff und/oder Siliziumkarbid bestehende Schichten aufgebracht werden, sodann der Träger aus so hergestellter Matrix ausgeschnitten, der ausgeschnittene Träger einer Hochtemperaturreinigung unterzogen und sodann eine oder mehrere aus SiC bestehende Schichten auf die Pyrokohlenstoffschicht aufgebracht wird.

Bevorzugterweise beläuft sich das Verhältnis von Gerüst zu Matrix wie 1 : 13 bis 1 : 17, insbesondere in etwa 1 : 14.

Das Verhältnis von Pyrokohlenstoff zu Siliziumkarbid, die die Matrix bilden, sollte sich belaufen auf 1 : 1,8 bis 1 : 2, vorzugsweise in etwa 1 : 1,86.

Bevorzugterweise beläuft sich die Gesamtdichte des Trägers auf 1,50 g/cm³ bis 1,9 g/cm³, wobei der Anteil der Fasern 0,098 g/cm³ bis 0,12 g/cm³, der Anteil des Pyrokohlenstoffs 0,4 g/cm³ bis 0,8 g/cm³ und der Anteil des SiC 0,8 g/cm³ bis 1,0 g/cm³ beträgt. Ein entsprechender Träger weist eine Wärmeleitfähigkeit von in etwa 14 W/mK auf.

Der erfindungsgemäße aus porösem Material bestehende Träger gestattet es, Gase während eines Behandlungsprozesses durch den Träger bzw. Suszeptor zu leiten. So kann z. B. die Rückseite eines Gegenstandes während eines Epitaxiprozesses vor Abscheidung geschützt werden, sofern durch den Suszeptor ein Spül- oder Reinigungsgas geleitet wird. Ferner kann durch das Reinigungsgas sichergestellt werden, dass Dotieratome, die während des Epitaxiprozesses aus der Rückseite des Gegenstandes heraustreten, mit dem Gasstrom abtrarisportiert werden, so dass eine Selbstdotierung der Vorderseite des Gegenstandes stark reduziert wird.

Insbesondere wird der erfindungsgemäße Träger dann verwendet, wenn Vorder- und Rückseite eines zu behandelnden Gegenstandes unterschiedlich prozessiert werden sollen. So kann durch die Verwendung des erfindungsgemäßen Trägers eine allseitig vorhandene Oxidschicht eines Gegenstandes so abgeätzt werden, dass nur die Vorderseite gezielt vom Oxid befreit wird. Undefiniertes Einbringen von Ätzgas zwischen Träger und Gegenstand, das zu einer teilweisen Abätzung der Oxidschicht im Randbereich der Rückseite des Gegenstandes führen kann, wird vermieden, so dass in Folge dessen die Oxidschicht auf der Rückseite geschützt ist.

Wird das Ätzgas nicht nur über den Gegenstand sondern auch durch den Träger geleitet, so kann auch die Rückseite des Gegenstandes vollständig und gleichmäßig abgeätzt werden. Entsprechendes gilt für die Dotierung von Gegenständen. So kann durch den Einsatz des erfindungsgemäß porösen Trägers die Rückseite eines Gegenstandes durch Spülgase vor Dotierung geschützt werden bzw. durch Zuführung von Dotiergasen durch den Träger eine gleichmäßige Dotierung von Vorder- und Rückseite erreicht werden.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung von den Darstellungen zu entnehmenden bevorzugten Ausführungsformen sowie nachfolgenden Beispielen.

Es zeigen:
- Fig. 1.: einen Querschnitt durch einen Träger mit von diesem aufgenommenen Gegenstand,
- Fig. 2: den Träger in Draufsicht,
- Fig. 3: eine Vergrößerung des Trägers gemäß Fig. 1 und 2 entlang einer Bruchkante,
- Fig. 4: ein vergrößerter Oberflächenausschnitt des Trägers nach den Fig. 1 bis 3 und
- Fig. 5: eine Detailabbildung einer Faser des Trägers nach den Fig. 1 bis 4.

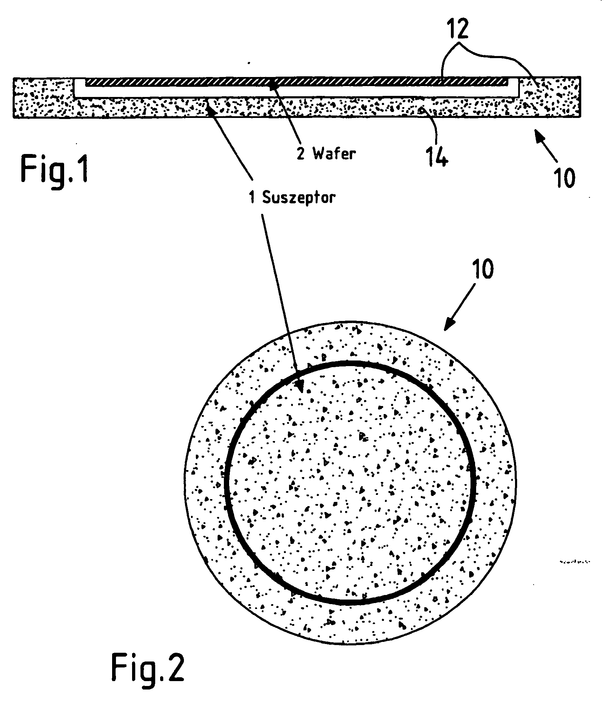

In Fig. 1 ist ein Träger 10 - auch Suszeptor genannt - dargestellt, der in einer nicht dargestellten Prozesskammer angeordnet ist und einen zu behandelnden bzw. zu reinigenden Gegenstand 12 aufnimmt, der z.B. ein Wafer sein kann. Der Träger 10 weist dabei in Draufsicht eine Kreisform auf, wie die Fig. 2 verdeutlicht. Andere Geometrien sind gleichfalls möglich. Im Ausführungsbeispiel weist der Träger 10 einen umlaufenden Rand 12 auf, zu dem zurückversetzt eine Bodenwandung 14 verläuft, oberhalb der der Gegenstand 12 angeordnet ist.

Mit anderen Worten weist der Träger 12 im Schnitt eine U-Form auf, oberhalb deren Querschenkel, der die Bodenwandung 14 bildet, der zu behandelnde bzw. reinigende Gegenstand 12 - nachstehend vereinfacht Wafer genannt - angeordnet ist.

Erfindungsgemäß besteht der Träger 10 aus einem aus Kohlenstoff- und/oder Siliziumkarbidfasern gebildeten Gerüst. Als Material können ein Filz, ein Vlies oder Gewebelagen benutzt werden. Sofern diese nicht in Kohlenstoff vorliegen, kann zuvor eine Verkokung erfolgen. Sodann erfolgt eine Stabilisierung der Fasern 16, 18 durch Gasphaseninfiltration (CVI) mit Pyrokohlenstoff (PyC) und/oder Siliziumkarbid (SiC). Auch kann eine Imprägnierung mit entsprechenden flüssigen Substanzen erfolgen.

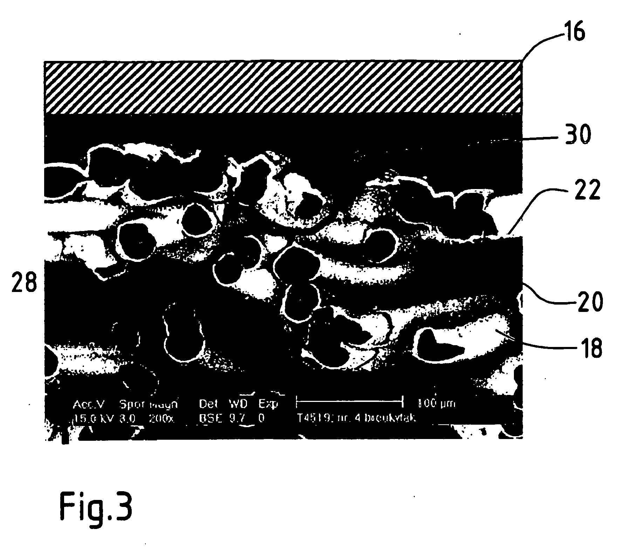

Die auf den Fasern 16, 18 aufgebrachten Schichten sind in der Fig. 3 beispielhaft mit den Bezugszeichen 20, 22 gekennzeichnet. Ein genauer Aufbau der mit den Schichten versehenen Fasern ergibt sich aus der Fig. 5. Dabei ist beispielhaft mit dem Bezugszeichen 24 eine Kohlenstofffaser im Schnitt dargestellt, die von einer oder mehreren Pyrokohlenstoffschichten 26 umgeben ist, die ihrerseits außenseitig von einer oder mehreren Siliziumkarbidschichten 28 umschlossen ist. Eine andere Schichtfolge von Pyrokohlenstoff und Siliziumkarbid kann gleichfalls vorliegen.

Durch die Dicke der aufgetragenen Schichten 26, 28 und Faserdurchmesser sowie deren Anordnung zueinander kann der Freiraum zwischen den beschichteten Fasern 18, 20 eingestellt werden und somit die Durchlässigkeit. Mit anderen Worten werden durch die Porosität Gasaustritts- bzw. -durchtrittsöffnungen und deren Verteilung bzw. Verlauf vorgegeben. Somit ist auf Grund des Gerüstmaterials eine Struktur gegeben, die zufällig angeordnete isotrop verteilte Porenkanäle zur Verfügung stellt, durch die Gas strömen kann. Ein entsprechender Gasstromweg ist in Fig. 3 mit einem Pfeil (Bezugszeichen 30) beispielhaft eingezeichnet. Hierdurch bedingt weist das den Träger 10 durchströmende Gas in diesem eine lange Verweilzeit auf, so dass eine gleichmäßige Erwärmung erfolgt. Ferner ist auf Grund der Porosität, also der Vielzahl sehr kleiner Kanäle, ein Gasstrom mit hoher Homogenität erzielbar. Da die Dimensionierung und Anordnung der Gasaustrittsöffnungen nicht mechanisch hergestellt werden, sondern allein durch den Aufbau des Gerüstes und dessen Beschichtung bestimmt sind, können im Vergleich zu mechanisch hergestellte Öffnungen aufweisenden Trägern oder Suszeptoren Vorteile erzielt werden, die sicherstellen, dass Gegenstände, die von dem erfindungsgemäßen Träger 10 aufgenommen sind, reproduzierbar im gewünschten Umfang behandelbar bzw. beschichtbar sind.

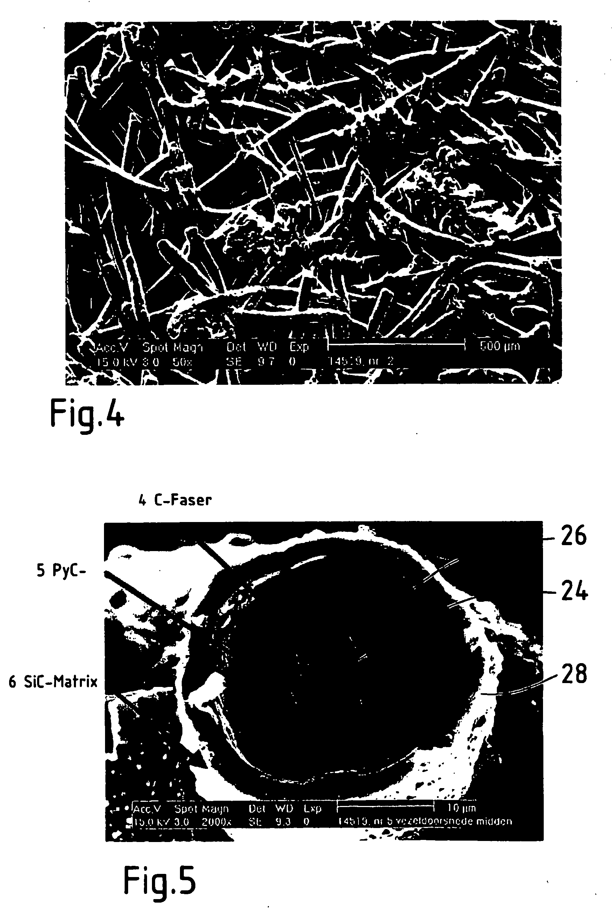

Die zufällig angeordneten isotrop verteilten Porenöffnungen, also Enden der Porenkanäle, ergeben sich aus der Darstellung im Bild gemäß Fig. 4.

Nachstehend wird die Erfindung an Hand eines Ausführungsbeispiels näher erläutert. Als Basismaterial für den Träger 10 kann ein Graphitfilz mit einer Gesamtverunreinigung von weniger 5 ppm benutzt werden. Elementbezogen liegen die Verunreinigungen unter 0,05 ppm. Ein entsprechender als Gerüst bezeichneter Graphitfilz kann durch Gasphaseninfiltration (CVI) mit Pyrokohlenstoff (PyC) und Siliziumkarbid (SiC) stabilisiert und verdichtet werden. Durch Variationen des Basismaterials sowie Veränderung der CVI-Schritte können die physikalischen Eigenschaften der so hergestellten Matrix in weiten Bereichen verändert und den jeweiligen Anforderungen angepasst werden. Dies ergibt sich beispielhaft aus den nachstehenden Tabellen.

So ist in Tabelle 1 der Zusammenhang zwischen Materialdichte und Wärmeleitfähigkeit wiedergegeben.

| Variante | Dichte (g/cm³) | Wärmeleitfähigkeit (W/mK) |
|---|---|---|
| A | 0,6 | 3,4 |
| B | 1,0 | 6,4 |
| C | 1,5 | 13 |
| D | 1,9 | 18 |

Durch veränderte Verhältnisse von Kohlenstofffasern, Pyrokohlenstoff und Siliziumkarbid können bei gleicher Dichte unterschiedliche Wärmeleitfähigkeiten eingestellt werden.

In Tabelle 2 ist der Zusammenhang zwischen Materialdichte und Porosität wiedergegeben.

| Variante | Dichte (g/cm³) | Porosität (%) |
|---|---|---|
| A | 0,6 | 75 |
| B | 1,0 | 60 |
| C | 1,5 | 38 |
| C | 1,5 | 45 |
| E | 1,9 | 27 |

Durch veränderte Verhältnisse von Kohlenstofffasern, Pyrokohlenstoff und Siliziumkarbid können bei gleicher Dichte unterschiedliche Porositäten eingestellt werden.

Die Erfindung wird nachstehend auch anhand eines Beispiels näher erläutert, dem weitere Einzelheiten und Vorteile zu entnehmen sind.

Zur Herstellung eines Trägers wird ein Filzrohling zunächst mit Pyrokahlenstoff verdichtet. Dies kann im CVI-Verfahren erfolgen. Hierzu erfolgt eine Zersetzung eines kohlenstoffhaltigen Gases (z. B. Methan) bei Temperaturen zwischen 800 °C und 1800 °C bei Drucken zwischen 0,01 mbar und 1013 mbar absolut. Sodann erfolgt eine Bearbeitung des verdichteten Filzrohlings, um die Trägergeometrie zu erzielen. Die Bearbeitung kann maschinell erfolgen. Anschließend wird eine Hochtemperaturreinigung durchgeführt. Hierzu wird der bearbeitete Gegenstand bei ≥ 2000 °C im Vakuum gehalten. Halogenhaltige Gase werden dem Reaktionsraum zugeführt. Durch die Hochtemperaturreinigung ergibt sich eine Gesamtverunreinigung < 5 ppm in der Achse insgesamt, wobei pro Einzelelement ein Wert < 0,05 ppm erzielbar ist, jeweils bezogen auf das Ausgangsgewicht. Schließlich erfolgt eine Verdichtung mit Siliziumkarbid, vorzugsweise im CVI-Verfahren. Dabei erfolgt die Zersetzung eines oder mehrerer silizium- und/oder kohlenstoffhaltiger Gase wie z. B. Methyltrichlorsilan bei Temperaturen zwischen 800 °C und 1600 °C und Drucken zwischen 0,01 mbar und 1013 mbar absolut.

Alternativ kann das Verdichten mit Pyrokohlenstoff bzw. Verdichten mit Siliziumcarbid durch Flüssigimprägnierung durchgeführt werden. Dabei wird eine Matrix durch Tränken in kohlenstoff- und/oder siliziumhaltigen Harzen oder Lösungen wie Phenolharz aufgebracht. Anschließend erfolgt ein Glühen im Vakuum oder Schutzgas.

Um z. B. bei Beibehaltung von Dichte und Porosität die Wärmeleitfähigkeit des Trägers zu ändern, können verschiedene Ausgangsfilzrohlinge benutzt werden. Ersetzt man z. B. Panoxfasern durch Pechfasem, so ergibt sich aufgrund höherer Wärmeleitfähigkeit der Fasern bei gleicher Porosität eine höhere Wärmeleitfähigkeit des Trägers.

Erfindungsgemäße Träger können z.B. Durchmesser von bis zu 500mm oder mehr und/oder Dicken von bis zu 5mm oder mehr aufweisen.

Ist bevorzugterweise eine Scheibengeometrie für den Suszeptor gewählt, so können nach der erfindungsgemäßen Lehre Suszeptoren anderer Geometrien gleichfalls hergestellt werden.

## Patentansprüche

1. Träger (10) zur Aufnahme eines zu behandelnden Gegenstandes (12), wie Substrat eines Halbleiterbauelementes, wobei der Träger Kohlenstoff enthält und den Träger durchsetzende Gasaustritts- oder Durchtrittsöffnungen aufweist,
**dadurch gekennzeichnet,**
**dass** die Gasaustritts- oder Durchtrittsöffnungen nicht mechanisch hergestellt sind, dass der Träger (10) aus einem Gerüst oder einem Abschnitt eines Gerüstes aus C-Fasern und/oder SiC-Fasern (18, 20) besteht, die in einer durch Gasphaseninfiltration und/oder Flüssigkeitsimprägnierung hergestellten Matrix aus Kohlenstoff und/oder SiC stabilisiert und eingebettet sind und dass Porosität p des Trägers 5 % ≤ p ≤ 95 % und Dichte ρ des Trägers 0,1 g/cm³ ≤ ρ ≤ 3,0 g/cm³ beträgt.

2. Träger nach Anspruch 1,
**dadurch gekennzeichnet,**
**dass** das Gerüst aus Kohlenstofffilz, -vlies und/oder -gewebelagen besteht.

3. Träger nach Anspruch 1,
**dadurch gekennzeichnet,**
**dass** die Fasern (18, 20) mit einer oder mehreren Kohlenstoff- wie Pyrokohlenstoff- und/oder Siliziumkarbidschichten (26, 28) als die Matrix versehen sind.

4. Träger nach zumindest einem der vorhergehenden Ansprüche,
**dadurch gekennzeichnet,**
**dass** die Matrix außenseitig eine Siliziumkarbidschicht aufweist.

5. Träger nach zumindest einem der vorhergehenden Ansprüche,
**dadurch gekennzeichnet,**
**dass** die Matrix ein Schichtsystem aufweist, das gradiert von Kohlenstoff in Siliziumkarbid übergeht.

6. Träger nach zumindest einem der vorhergehenden Ansprüche,
**dadurch gekennzeichnet,**
**dass** die Wärmeleitfähigkeit w des Trägers (10) sich beläuft auf 0,10 W/mK = w = 100 W/mK, insbesondere auf 3 W/mk = w = 30 W/mk.

7. Träger nach zumindest einem der vorhergehenden Ansprüche,
**dadurch gekennzeichnet,**
**dass** der Träger eine Gesamtdichte von 1,50 g/cm³ bis 1,9 g/cm³ aufweist, wobei der Anteil der Fasern 0,098 g/cm³ bis 0,2 g/cm³ und/oder der Anteil des Pyrokohlenstoffs 0,4 g/cm³ bis 0,8 g/cm³ und/oder der Anteil des SiC 0,8 g/cm³ bis 1,0 g/cm³ beträgt.

8. Träger nach zumindest einem der vorhergehenden Ansprüche,
**dadurch gekennzeichnet,**
**dass** das Gewichtsverhältnis von Gerüst zu Matrix sich beläuft auf in etwa 1 : 13 bis 1 : 17.

9. Verfahren zur Herstellung eines Trägers zur Aufnahme eines zu behandelnden Gegenstandes, vorzugsweise eines Substrats eines Halbleiterbauelementes wie Wafer, wobei als Material für den Träger Kohlenstoff verwendet wird und in dem Träger diesen durchsetzende Gasaustritts- oder Durchtrittsöffnungen ausgebildet werden,
**gekennzeichnet durch** die Verfahrensschritte,
- Herstellen eines Gerüstes aus C- und/oder SiC-Fasern,
- Stabilisieren des Gerüstes mit zumindest einer **durch** Gasphaseninfiltration und/oder Flüssigkeitsimprägnierung hergestellten eine Matrix bildenden Pyrokohlenstoff- und/oder Siliziumcarbidschicht unter gleichzeitiger Ausbildung von isotrop verteilten Porenkanälen als die nicht mechanisch hergestellten Gasaustritts- oder Durchtrittsöffnungen,
wobei das stabilisierte Gerüst oder ein Abschnitt des stabilisierten Gerüstes als der Träger verwendet wird.

10. Verfahren nach Anspruch 9,
**dadurch gekennzeichnet,**
**dass** die Fasern durch Gasphaseninfiltration (CVI) und/oder Flüssigkeitsimprägnierung stabilisiert werden.

11. Verfahren nach Anspruch 9 oder 10,
**dadurch gekennzeichnet,**
**dass** als das Gerüst stabilisierter Filz oder Vlies oder stabilisierte Gewebelagen verwendet werden.

12. Verfahren nach zumindest einem der Ansprüche 9 bis 11,
**dadurch gekennzeichnet,**
**dass** die Fasern ausschließlich mit Kohlenstoff oder ausschließlich mit Siliziumkarbid stabilisiert werden.

13. Verfahren nach zumindest einem der Ansprüche 9 bis 12,
**dadurch gekennzeichnet,**
**dass** die Fasern mit einer Folge von einer oder mehreren aus Kohlenstoff und/oder Siliziumkarbid bestehenden Schichten stabilisiert werden.

14. Verfahren nach zumindest einem der Ansprüche 9 bis 13,
**dadurch gekennzeichnet,**
**dass** die Fasern mit einem von Kohlenstoff in Siliziumkarbid übergehenden gradierten Schichtsystem stabilisiert werden.

15. Verfahren nach zumindest einem der Ansprüche 9 bis 14,
**dadurch gekennzeichnet,**
**dass** das Gerüst derart stabilisiert wird, dass als Außenschicht eine Siliziumkarbidschicht ausgebildet wird.

16. Verfahren nach zumindest einem der Ansprüche 9 bis 15,
**dadurch gekennzeichnet,**
**dass** durch Zusammensetzung des Gerüstes und/oder Dauer der Gasphaseninfiltration bzw. Flüssigkeitsimprägnierung Dichte, Wärmeleitfähigkeit und/oder Porosität des Trägers eingestellt wird.

17. Verfahren nach zumindest Anspruch 9,
**dadurch gekennzeichnet,**
**dass** der Träger auf eine Porosität p mit 5 % = p = 95 %, insbesondere 10 % = p = 95 %, eingestellt wird.

18. Verfahren nach zumindest Anspruch 9,
**dadurch gekennzeichnet,**
**dass** der Träger auf eine Dichte ρ mit 0,1 g/cm³ = ρ = 3,0 g/cm³ eingestellt wird.

19. Verfahren nach zumindest einem der Ansprüche 9 bis 17,
**gekennzeichnet durch** die Verfahrensschritte,
- Aufbringen einer oder mehrerer aus Pyrokohlenstoff bestehenden Schichten auf das aus C- und/oder SiC-Fasern bestehende Gerüst,
- Ausschneiden des Trägers aus dem beschichteten Gerüst,
- Hochtemperaturreinigung des ausgeschnittenen Trägers und
- Aufbringen einer oder mehrerer aus Siliziumkarbid bestehenden Schichten auf das mit Pyrokohlenstoff beschichtete Gerüst.

## Claims

1. A carrier (10) designed to receive an object (12) to be treated, such as a substrate for a semiconductor element, the carrier containing carbon and comprising gas outlet openings or passage openings extending through the carrier,
**characterized in**
**that** the gas outlet openings or passage openings are not mechanically made, that the carrier (10) consists of a framework or a part of a framework made of C fibers and/or SiC fibers (18, 20) which are embedded and stabilized in a matrix made of carbon and/or SiC, and that porosity p of the carrier is of 5% ≤ p ≤ 95% and density ρ of the carrier is of 0.1 g/cm³ ≤ ρ ≤ 3.0 g/cm³.

2. A carrier according to Claim 1,
**characterized in**
**that** the framework consists of carbon felt, non-woven material and/or fabric layers.

3. A carrier according to Claim 1,
**characterized in**
**that** the fibers (18, 20) are provided with one or more carbon as pyrocarbon and/or silicon carbide layers (26, 28) as the matrix.

4. A carrier according to at least one of the preceding claims,
**characterized in**
**that** the matrix is provided on its outer surface with a silicon carbide coating.

5. A carrier according to at least one of the preceding claims,
**characterized in**
**that** the matrix comprises a coating system that passes over in a graduated fashion from carbon to silicon carbide.

6. A carrier according to at least one of the preceding claims,
**characterized in**
**that** the thermal conductivity w of the carrier (10) amounts to 0.10 W/mK = w = 100 W/mK, especially to 3 W/mk = w = 30 W/mk.

7. A carrier according to at least one of the preceding claims,
**characterized in**
**that** the carrier has a total density of 1.50 g/cm³ to 1.9 g/cm³, whereby the proportion of the fibers amounts 0.098 g/cm³ to 0.2 g/cm³ and/or the proportion of the pyrocarbon amounts 0.4 g/cm³ to 0.8 g/cm³ and/or the proportion of SiC amounts 0.8 g/cm³ to 1.0 g/cm³.

8. A carrier according to at least one of the preceding claims,
**characterized in**
**that** the weight ratio of framework to matrix amounts to approximately 1 : 13 to 1 : 17.

9. A method for producing a carrier for receiving an object to be processed, preferably a substrate of a semiconductor element such as a wafer, whereby carbon is used as material for the carrier and gas outlet openings or passage openings passing through the carrier are formed in the latter,
**characterized by** the process steps:
- production of a framework made of carbon and/or SiC fibers and
- stabilization of the framework with at least one pyrocarbon and/or silicon carbide layer forming a matrix and being produced by vapor infiltration by simultaneous formation of isotopic distributed pore channels as the gas outlet openings or passage openings being not mechanically produced,
whereby the stabilized framework or a segment of the stabilized framework is used as the carrier.

10. A method according to claim 9,
**characterized in**
**that** the fibers are stabilized by means of vapor infiltration (CVI) and/or fluid impregnation.

11. A method according to claim 9 or 10,
**characterized in**
**that** stabilized felt or fleece or stabilized non-woven material layers are used as the framework.

12. A method according to at least one of claims 9 through 11,
**characterized in**
**that** the fibers are stabilized exclusively with carbon or exclusively with silicon carbide.

13. A method according to at least one of claims 9 through 12,
**characterized in**
**that** the fibers are stabilized with a series of one or more coatings consisting of carbon and/or silicon carbide.

14. A method according to at least one of claims 9 through 13,
**characterized in**
**that** the fibers are stabilized with a graduated system of coatings that transitions from carbon into silicon carbide.

15. A method according to at least one of claims 9 through 14,
**characterized in**
**that** the framework is stabilized in such a way that a silicon carbide coating is formed as the outer layer.

16. A method according to at least one of claims 9 through 15,
**characterized in**
**that** the density, thermal conductivity and/or porosity of the carrier is adjusted by the composition of the framework and/or duration of the vapor infiltration or fluid impregnation.

17. A method according to at least claim 9,
**characterized in**
**that** the carrier is adjusted to a porosity level p of 5% = p = 95%, especially 10% = p = 95%.

18. A method according to at least claim 9,
**characterized in**
**that** the carrier is adjusted to a density ρ of 0.1 g/cm³ = ρ = 3.0 g/cm³.

19. A method according to at least one of claims 9 through 17,
**characterized by** the process steps:
- applying one or more coatings consisting of pyrocarbon to the framework made of carbon and/or SiC fibers,
- cutting of the carrier from the coated framework,
- high-temperature cleaning of the cut-out carrier and
- applying one or more coatings made of silicon carbide to the framework coated with pyrocarbon.

## Revendications

1. Support (10) destiné à loger un objet à traiter (12), tel que le substrat d'un semi-conducteur, sachant que le support contient du carbone et présente des ouvertures de passage et de sortie de gaz le traversant,
**caractérisé en ce**
**que** les ouvertures de passage ou de sortie de gaz ne sont pas fabriquées de manière mécanique, que le support (10) est constitué d'une structure ou d'une section de structure en fibres de carbone et/ou en fibres SiC (18, 20) qui sont stabilisées et enrobées dans une matrice en carbone et/ou SiC fabriquée par infiltration en phase vapeur et/ou imprégnation liquide, et que la porosité p du support s'élève à 5 % ≤ p ≤ 95 % et la densité ρ du support à 0,1 g/cm³ ≤ ρ ≤ 3,0 g/cm³.

2. Support selon la revendication 1,
**caractérisé en ce**
**que** la structure est constituée de feutre de carbone, de non-tissé de carbone et/ou de couches de tissu carbone.

3. Support selon la revendication 1,
**caractérisé en ce**
**que** les fibres (18, 20) sont pourvues, en tant que matrice, d'une ou plusieurs couche(s) (26, 28) de carbone telles que des couches de pyrocarbone et/ou de carbure de silicium.

4. Support selon au moins une des revendications précédentes,
**caractérisé en ce**
**que** la matrice présente du côté extérieur une couche de carbure de silicium.

5. Support selon au moins une des revendications précédentes,
**caractérisé en ce**
**que** la matrice présente un système de couches qui passe graduellement du carbone au carbure de silicium.

6. Support selon au moins une des revendications précédentes,
**caractérisé en ce**
**que** la conductibilité thermique w du support (10) s'élève à 0,10 W/mK = w = 100 W/mK, en particulier à 3 W/mk = w = 30 W/mk.

7. Support selon au moins une des revendications précédentes,
**caractérisé en ce**
**que** le support présente une densité totale comprise entre 1,50 g/cm³ et 1,9 g/cm³, sachant que la part de fibres est comprise entre 0,098 g/cm³ et 0,2 g/cm³ et/ou la part de pyrocarbone entre 0,4 g/cm³ et 0,8 g/cm³ et/ou la part de SiC entre 0, 8 g/cm³ et 1,0 g/cm³.

8. Support selon au moins une des revendications précédentes,
**caractérisé en ce**
**que** le rapport pondéral structure - matrice est compris environ entre 1 : 13 et 1 : 17.

9. Procédé de fabrication d'un support destiné à loger un objet à traiter, de préférence le substrat d'un semi-conducteur, tel qu'une tranche, sachant que du carbone est utilisé comme matériau pour le support, et que dans ce support sont formées des ouvertures de passage ou de sortie de gaz qui le traversent,
**caractérisé par** les étapes suivantes :
- Fabrication d'une structure en fibres de carbone et/ou en fibres SiC
- Stabilisation de la structure avec au moins une couche de carbure de silicium et/ou de pyrocarbone fabriquée par infiltration en phase vapeur et/ou imprégnation liquide et formant une matrice, avec formation simultanée de canaux de pores répartis de manière isotrope en tant qu'ouvertures de passage et/ou de sortie de gaz fabriquées non mécaniquement,
sachant que la structure stabilisée ou une section de la structure stabilisée est utilisée comme support.

10. Procédé selon la revendication 9,
**caractérisé en ce**
**que** les fibres sont stabilisées par infiltration en phase vapeur (CVI) et/ou par imprégnation liquide.

11. Procédé selon la revendication 9 ou 10,
**caractérisé en ce**
**que** du feutre stabilisé ou du non-tissé ou des couches de tissus stabilisées sont utilisés pour la structure.

12. Procédé selon au moins une des revendications 9 à 11,
**caractérisé en ce**
**que** les fibres sont stabilisées exclusivement avec du carbone ou exclusivement avec du carbure de silicium.

13. Procédé selon au moins une des revendications 9 à 12,
**caractérisé en ce**
**que** les fibres sont stabilisées à l'aide d'une succession d'une ou plusieurs couche(s) composées de carbone et/ou de carbure de silicium.

14. Procédé selon au moins une des revendications 9 à 13,
**caractérisé en ce**
**que** les fibres sont stabilisées à l'aide d'un système de couches passant graduellement du carbone au carbure de silicium.

15. Procédé selon au moins une des revendications 9 à 14,
**caractérisé en ce**
**que** la structure est stabilisée de telle manière qu'une couche de carbure de silicium est formée en tant que couche extérieure.

16. Procédé selon au moins une des revendications 9 à 15,
**caractérisé en ce**
**que** l'assemblage de la structure et/ou la durée de l'infiltration en phase vapeur ou de l'imprégnation liquide permet(tent) d'ajuster la densité, la conductibilité thermique et/ou la porosité du support.

17. Procédé selon au moins la revendication 9,
**caractérisé en ce**
**que** le support est ajusté sur une porosité p de 5 % = p = 95 %, en particulier de 10 % = p = 95 %.

18. Procédé selon au moins la revendication 9,
**caractérisé en ce**
**que** le support est ajusté sur une densité ρ de 0, 1 g/cm³ = ρ = 3,0 g/cm³.

19. Procédé selon au moins une des revendications 9 à 17,
**caractérisé par** les étapes suivantes :
- Application d'une ou plusieurs couche(s) constituée(s) de pyrocarbone sur la structure composée de fibres de carbone et/ou de fibres SiC,
- Découpage du support dans la structure formée par les couches,
- Nettoyage à haute température du support découpé et
- Application d'une ou plusieurs couches composées de carbure de silicium sur la structure recouverte de pyrocarbone.
